# EUROPÄISCHE PATENTANMELDUNG

(11) **EP 3 480 164 A1**
(43) Veröffentlichungstag der Anmeldung: **08.05.2019**
(21) Anmeldenummer: 18204901.5
(22) Anmeldetag: 07.11.2018
(51) Int. Cl.: B81B 7/00, B81C 1/00

(54) **VERFAHREN ZUR HERSTELLUNG VON PLANAREN DÜNNEN PACKAGES FÜR HALBLEITERBAUELEMENTE UND PLANARE DÜNNE PACKAGES**

(30) Priorität: 07.11.2017 DE 102017219711
(71) Anmelder: FRAUNHOFER-GESELLSCHAFT zur Förderung der angewandten Forschung e.V., 80686 München (DE)
(72) Erfinder: LANDESBERGER, Christof, 82166 Gräfelfing (DE); BOSE, Indranil, 80335 München (DE)
(74) Vertreter: Stöckeler, Ferdinand

(57) **Zusammenfassung**

Ein Verfahren zum Herstellen eines Halbleiterbauelement-Package umfasst ein Bereitstellen einer elektrisch isolierenden Folie mit Folien-Anschlusskontakten auf einer Oberfläche derselben und einer Öffnung durch dieselbe. Eine Halbleiterbauelement-Anordnung, die zumindest ein Trägerelement aufweist, auf dem ein vorstehendes Element und Element-Anschlusskontakte angeordnet sind, wird auf die Folie aufgebracht, wobei das vorstehende Element in die Öffnung eingebracht wird und die Element-Anschlusskontakte in Kontakt mit den Folien-Anschlusskontakten angeordnet werden. Eine Planarisierungsschicht wird über dem Trägerelement und der Folie aufgebracht.

## Beschreibung

Nach dem Stand der Technik werden MEMS-Sensoren in einem Package auf eine Leiterplatte oder eine flexible Folie auf die Oberflache montiert. Dadurch ist das Package an der Stelle des Sensors dicker. Bei manchen Anwendungen wie Strömungssensoren oder Drucksensoren in strömenden Medien ist es wichtig, dass die Oberfläche glatt und planar ist, um keine Wirbel und Turbulenzen zu erzeugen und eine laminare Strömung nicht zu stören.

Bisher wurden MEMS-Sensoren in Gehäuse verpackt verkauft und mit diesem Gehäuse auf Leiterplatten montiert. Auch kleine SMD-Gehäuse (Surface Mount Device) haben eine Dicke in der Größenordnung von Millimetern.

ASICS, Controller, viele andere Schaltungen aus Silizium werden auch als bare die (= Siliziumchips ohne Gehäuse) im inneren einer Leiterplatte montiert und elektrisch verbunden. Sie sind jedoch allseits von der Leiterplatte und den Klebstoffen umschlossen, um vor Umwelteinflüssen, wie Feuchte und Korrosion geschützt zu sein. Bei MEMS-Sensoren wie Drucksensoren ist aber ein Kontakt zumindest der sensitiven Flache des Siliziumchips zur Umwelt notwendig. Dies gilt auch für andere chemische Sensoren (pH-Wert, Gase und Ionen in Flüssigkeiten, Salzgehalt) und physikalische Sensoren (Temperatur, Druck, Schall, Strahlung, Beschleunigung), falls auch eine dünne, abdeckende Schicht die Empfindlichkeit des Sensors beeinträchtigt.

Es besteht ein Bedarf nach planaren dünnen Packages für Halbleiterbauelement-Anordnungen und Verfahren zum Herstellen solcher Packages.

Beispiele der vorliegenden Offenbarung schaffen ein Verfahren zum Herstellen eines Halbleiterbauelement-Package mit folgenden Merkmalen:
Bereitstellen einer elektrisch isolierenden Folie mit Folien-Anschlusskontakten auf einer Oberfläche derselben und einer Öffnung durch dieselbe;
Aufbringen einer Halbleiterbauelement-Anordnung, die zumindest ein Trägerelement aufweist, auf dem ein vorstehendes Element und Element-Anschlusskontakte angeordnet sind, auf die Folie, wobei das vorstehende Element in die Öffnung eingebracht wird und die Element-Anschlusskontakte in Kontakt mit den Folien-Anschlusskontakten angeordnet werden;

Aufbringen einer Planarisierungsschicht über dem Trägerelement und der Folie.

Beispiele der vorliegenden Offenbarung basieren auf der Erkenntnis, dass ein flaches bzw. planares Package (Gehäuse) für Halbleiterbauelement-Anordnungen implementiert werden kann, indem eine Halbleiterbauelement-Anordnung derart auf eine elektrisch isolierende Folie aufgebracht wird, dass Anschlusskontakte der Halbleiterbauelement-Anordnung direkt auf Folienanschlusskontakten angeordnet und mit diesen elektrisch leitfähig verbunden werden, und dass ein von dem Halbleiterbauelement vorstehendes Element in eine durch die Folie gebildete Öffnung eingebracht wird. Eine Planarisierungsschicht kann dann über dem Trägerelement und der Folie aufgebracht werden, das Package fertigzustellen. Somit kann ein Package hergestellt werden, dessen Gesamtdicke deutlich dünner als bisherige Gehäuse beispielsweise von Sensoren ist. Das Package kann lediglich aus zwei Lagen Folien bestehen, welche eine gehäuselosen Halbleiterbauelement-Anordnung seitlich umgeben und somit nicht zur Dicke beitragen, oder einer Folie mit einer Lage Einbettmaterial die die gehäuselose Halbleiterbauelement-Anordnung ebenfalls seitlich umgeben und somit nicht zur Dicke beitragen. Somit kann das ganze Package genauso dick oder nicht wesentlich dicker als sein als die Halbleiterbauelement-Anordnung. Darüber hinaus kann ein planes Package erhalten werden, bei dem die ursprüngliche Topographie der Halbleiterbauelement-Anordnung ausgeglichen ist.

Beispiele der vorliegenden Offenbarung werden nachfolgend Bezug nehmend auf die beiliegenden Zeichnungen näher erläutert. Es zeigen:
- Fig. 1a bis 1c: schematische Seitenansichten zur Erläuterung eines Beispiels eines Verfahrens gemäß der vorliegenden Offenbarung;
- Fig. 2 bis 10: schematische Darstellungen zur Erläuterung eines weiteren Beispiels gemäß der vorliegenden Offenbarung.

Im Folgenden werden Beispiele der vorliegenden Offenbarung detailliert unter Verwendung der beigefügten Zeichnungen beschrieben. Es darauf hingewiesen, dass in den Zeichnungen gleiche Elemente oder Elemente mit der gleichen Funktionalität mit gleichen oder ähnlichen Bezugszeichen versehen sein können, wobei eine wiederholte Beschreibung solcher Elemente weggelassen sein kann. Daher können Beschreibungen für Elemente mit gleichen oder ähnlichen Bezugszeichen gegenseitig austauschbar sein.

In der folgenden Beschreibung ist eine Mehrzahl von Einzelheiten dargelegt, um eine gründliche Erläuterung von Beispielen der vorliegenden Offenbarung zu liefern. Jedoch wird Fachleuten einleuchten, dass Beispiele der vorliegenden Offenbarung ohne diese spezifischen Einzelheiten praktiziert werden können. In anderen Fällen sind hinreichend bekannte Strukturen und Vorrichtungen in schematischer Querschnittansicht oder Draufsicht statt in Einzelheiten gezeigt, um die Beschreibung von Beispielen nicht zu verschleiern. Außerdem können Merkmale der hiernach beschriebenen verschiedenen Beispiele mit anderen Merkmalen anderer Beispiele kombiniert werden, es sei denn, es ist hierin ausdrücklich etwas anderes angegeben.

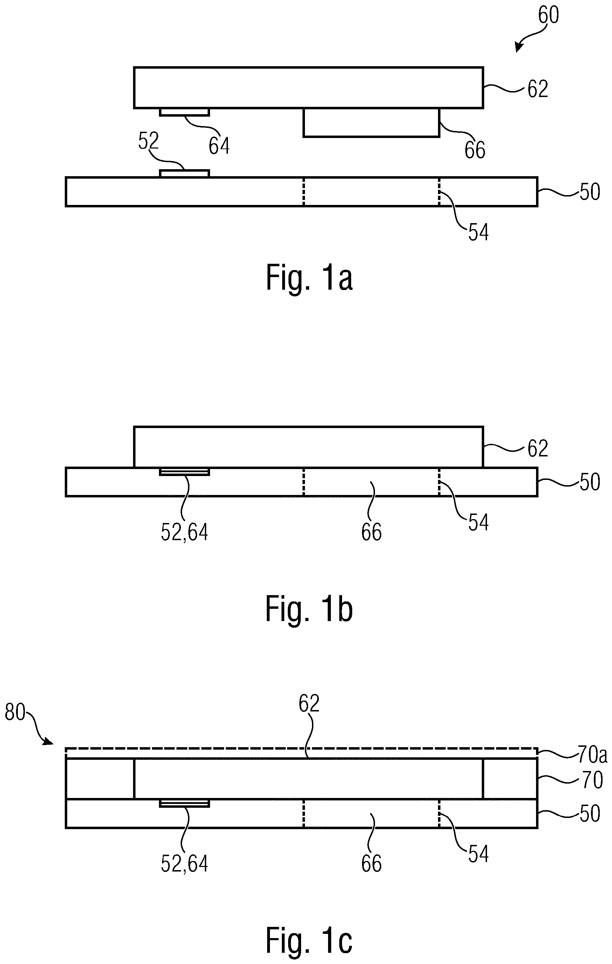

Fig. 1a zeigt schematisch eine Seitenansicht einer Folie 50, die aus einem elektrisch isolierenden Material, wie z.B. Polyimid, PI, oder Polyethylennaphthalat, PEN, besteht. Auf einer oberen Oberfläche der Folie sind Folien-Anschlusskontakte 52 gebildet. Durch die Folie 50 ist eine Öffnung 54 gebildet, die in der Seitenansicht durch gestrichelte Linien angedeutet ist. Bei Beispielen durchdringt die Öffnung 54 die Folie vollständig. Bei anderen Beispielen durchdringt die Öffnung 54 die Folie nicht vollständig, was jedoch aufwändiger herzustellen ist. Fig. 1a zeigt ferner eine Halbleiterbauelement-Anordnung 60, die ein Trägerelement 62, Element-Anschlusskontakte 64 und eine vorstehendes Element 66 aufweist. Die Anschlusskontakte 64 und das vorstehende Element sind auf der gleichen Oberfläche des Trägerelements 62 angeordnet.

Die Halbleiterbauelement-Anordnung wird auf die Folie 50 derart aufgebracht, dass das vorstehende Element in die Öffnung 54 eingebracht wird und die Element-Anschlusskontakte 64 auf den Folien-Anschlusskontakten 52 zu liegen kommen und dieselben mechanisch und elektrisch kontaktieren. Dies ist in Fig. 1b dargestellt. Die Anschlusskontakte können dabei in die Folie 50 gedrückt werden. Die Halbleiterbauelement-Anordnung 60 kann dabei an der Folie 50 befestigt werden. Bei Beispielen kann die Halbleiterbauelement-Anordnung 60 auf die Folie 50 geklebt werden. Dabei kann ein leitfähiger Kleber im Bereich der Anschlusskontakte und/oder ein nicht-leitender Kleber in anderen Bereichen verwendet werden. Bei Beispielen kann vor dem Aufbringen der Halbleiterbauelement-Anordnung ein Klebstoff auf den Bereich der Folien-Anschlusskontakte aufgebracht werden. Bei anderen Beispielen kann die Halbleiterbauelement-Anordnung 60 über ein Wärmeverfahren an der Folie 50 befestigt werden. Wie in Fig. 1b gezeigt ist, kann das vorstehende Element 66 an der von den Anschlusskontakten 52, 64 abgewandten Seite, d.h. in den Figuren der unteren Seite, bündig mit der Oberfläche der Folie 50 abschließen.

Nachfolgend wird eine Planarisierungsschicht 70 über dem Trägerelement 62 und der Folie 50 aufgebracht. Die Planarisierungsschicht 70 kann bei Beispielen aus einem Permanent-Resist, Epoxy oder einem Polymer bestehen. Das dadurch hergestellte Package 80 ist in Fig. 1c gezeigt.

Wie in Fig. 1c gezeigt ist, kann die Planarisierungsschicht auf der von dem vorstehenden Element 66 abgewandten Seite bündig mit der Oberfläche des Trägerelements 62 abschließen. Bei solchen Beispielen umgibt die Folie 50 das vorstehende Element seitlich und die Planarisierungsschicht umgibt das Trägerelement 62 seitlich. Auf der von dem vorstehenden Element 66 abgewandten Seite des Trägerelements 62 ist keine Planarisierungsschicht und auf der von dem Trägerelement 62 abgewandten Seite des vorstehenden Elements 66 ist keine Folie vorgesehen. Somit kann die Dicke des Package 80 im Wesentlichen der Dicke der Halbleiterbauelement-Anordnung 60 entsprechen. Somit kann ein möglichst dünnes Package realisiert werden. Bei anderen Beispielen kann auf der von dem vorstehenden Element 66 abgewandten Seite des Trägerelements eine dünne Planarisierungsschicht 70a belassen werden, wie durch gestrichelte Linien in Fig. 1c angedeutet ist.

Bei Beispielen wird vor dem Aufbringen der Halbleiterbauelement-Anordnung eine ablösbare Folie auf die Oberfläche der Folie aufgebracht, die den Folien-Anschlusskontakten 52 gegenüberliegt, d.h. von den Folien-Anschlusskontakten 52 abgewandt ist. Die ablösbare Folie kann nach dem Aufbringen der Planarisierungsschicht entfernt werden. Durch die Verwendung einer solchen ablösbaren Folie kann eine Handhabung während der Herstellung erleichtert werden.

Bei Beispielen weist die Folie eine Metallisierungsstruktur, die die Folien-Anschlusskontakte entsprechend einer Anschlusskontaktflächen-Geometrie, Kontaktpad-Geometrie, der Halbleiterbauelement-Anordnung und eine Fan-Out-Struktur, die zu größeren Anschlusspads führt, auf der Folie aufweist. Dadurch kann eine externe Kontaktierung des Package erleichtert werden, indem externe Anschlüsse mit den größeren Anschlusspads verbunden werden.

Bei Beispielen können Kontaktöffnungen von der Oberfläche der Folie, die den Folien-Anschlusskontakten gegenüberliegt, her durch die Folie erzeugt werden, die eine mit den Folien-Anschlusskontakten verbundene Metallisierung, beispielsweise die größeren Anschlusspads, freilegen. Dadurch ist es möglich, auf einfache Weise die Halbleiterbauelement-Anordnung in dem Package elektrisch zu kontaktieren, indem eine Anschlussverdrahtung für die Halbleiterbauelement-Anordnung durch die Öffnungen erzeugt wird.

Bei Beispielen können die Öffnung durch die Folie und/oder die Kontaktöffnungen mit geringem Aufwand mittels Laserschneiden erzeugt werden.

Bei Beispielen kann die Halbleiterbauelement-Anordnung ein MEMS-Chip sein. Unter MEMS versteht man ein elektromechanisches Mikrosystem, bei dem in der Regel ein oder mehrere Sensoren und/oder Aktoren und eine Steuerungselektronik auf einem Substrat bzw. Chip integriert sind. Bei Beispielen kann der MEMS-Chip ein MEMS-Substrat aufweisen, in dem ein oder mehrere Sensoren und/oder Aktoren und eine Steuerungslogik integriert sind, und eine MEMS-Kappe, die eine Abdeckung einer mechanischen Komponente, wie z.B. einem Sensor oder einem Aktor, darstellen kann. Eine solche MEMS-Kappe steht von dem MEMS-Substrat, das ein Trägerelement darstellt, vorsteht.

Bei Beispielen kann das vorstehende Element zumindest einen Halbleiterchip aufweisen und das Trägerelement kann ein Verdrahtungssubstrat oder ein Halbleitersubstrat aufweisen. Bei Beispielen kann die Halbleiterbauelement-Anordnung gestapelte Chips aufweisen. Bei solchen Beispielen kann das vorstehende Element einen ersten Halbleiterchip aufweisen und das Trägerelement kann einen zweiten Halbleiterchip aufweisen, wobei der erste Halbleiterchip und die Element-Anschlusskontakte auf einer Oberfläche des zweiten Halbleiterchips angeordnet sind.

Beispiele der vorliegenden Offenbarung ermöglichen somit ein Folien-basiertes Package (Gehäuse) von gestapelten Chips. Mögliche Anwendungsbeispiele sind gestapelte MEMS-Bauelemente, Speicher-Chip-Stapel ("memory stacks") oder Kombinationen von Prozessor-IC und Speicher-IC sowie weitere Kombinationen von Halbleiterbauelementen. Der hierin beschriebene Lösungsansatz bietet somit allgemein eine Package-Lösung für zweilagige oder mehrlagige Chip-Stapel, wie z.B. dreidimensionale IC-Stapel und multifunktionale Chip-Stapel.

Beispiele der vorliegenden Offenbarung schaffen ein dünnes Package, das unter Verwendung entsprechender Verfahren hergestellt wurde. Beispiele der vorliegenden Offenbarung schaffen ein dünnes Package für eine Halbleiterbauelement-Anordnung, die ein Trägerelement aufweist, auf dem ein vorstehendes Element und Element-Anschlusskontakte angeordnet sind, in einem zweilagigen Folienstapel, wobei eine elektrische Kontaktierung der Halbleiterbauelement-Anordnung zu Leiterbahnen auf der Oberfläche einer der Folien erfolgt, die einer zweiten der Folien zugekehrt ist, indem die Element-Anschlusskontakte auf Folien-Anschlusskontakten, die sich auf der Oberfläche der einen der Folien befinden, angeordnet sind, wobei die Leiterbahnen mittels Durchkontaktierungen auf eine der äußeren Oberflächen geführt sind, und wobei das vorstehende Element in einer Öffnung der einen der beiden Folien angeordnet ist.

Ein Beispiel eines solchen Package 80 ist in Fig. 1c gezeigt, bei dem die Folie 50 die eine der beiden Folien darstellt, und eine durch die Planarisierungsschicht 70 gebildete Folie die zweite der beiden Folien darstellt. Wie in Fig. 1c zu erkennen ist, erfolgt die Kontaktierung auf der Seite der Folie 50, die der anderen Folie 70 zugewandt ist, also auf der Innenseite.

Bei Beispielen eines Package (Gehäuses) gemäß der vorliegenden Offenbarung ist die Halbleiterbauelement-Anordnung ein MEMS-Sensorchip, das vorstehende Element ist eine MEMS-Kappe und das Trägerelement ist ein MEMS-Substrat. Bei Beispielen weist das vorstehende Element einen Halbleiterchip auf und das Trägerelement weist einen weiteren Halbleiterchip, ein Halbleitersubstrat oder ein Verdrahtungssubstrat auf.

Beispiele der vorliegenden Offenbarung sind allgemein auf Halbleiterbauelement-Anordnungen anwendbar, die auf einer Oberfläche eines Trägerelements vorstehende Element aufweisen, wie z.B. eine oder mehrere MEMS-Kappen oder ein oder mehrere Halbleiterchips. In einer Folie werden oder sind eine oder mehrere Öffnungen vorgesehen, deren äußere Kontur an die äußere Kontur der vorstehenden Elemente angepasst sein kann. Das oder die vorstehenden Elemente können dann in die Öffnung oder die Öffnungen eingebracht werden, so dass sie die Öffnung oder die Öffnungen im Wesentlichen ausfüllen. Unter einer Halbleiterbauelementanordnung ist eine Anordnung zu verstehen, die eine Halbleiterschaltung zumindest entweder in dem Trägerelement und/oder in dem vorstehenden Element aufweist.

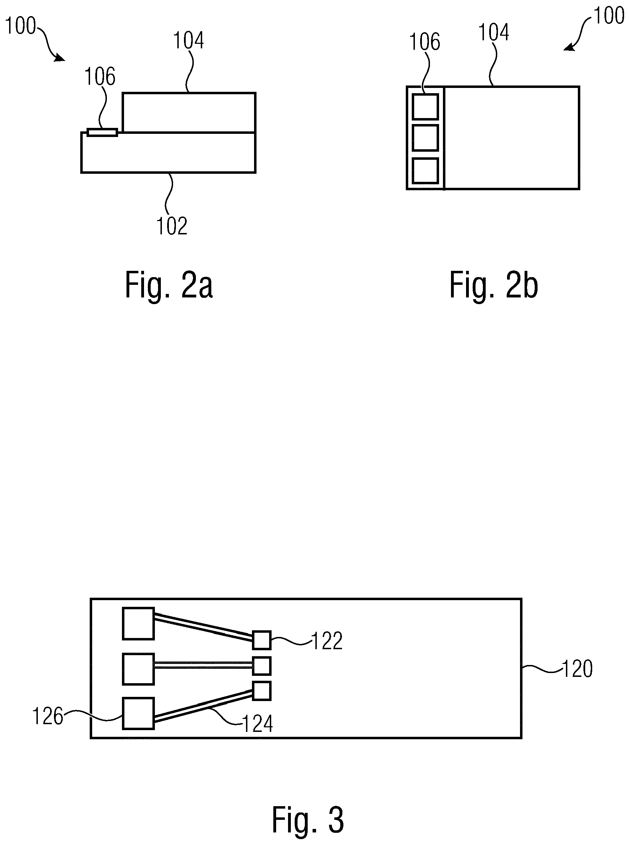

Ein Beispiel eines Verfahrens gemäß der vorliegenden Offenbarung, bei dem die Halbleiterbauelement-Anordnung ein MEMS-Sensorchip ist, wir nachfolgend Bezug nehmend auf die Figuren 2 bis 10 näher erläutert.

Solche Beispiele ermöglichen ein flaches bzw. planares Package (Gehäuse) für MEMS-Sensoren, welches die Eigenschaften einer Strömung eines Fluids (Gas, Luft, Flüssigkeit, Wasser) nicht verändert. So werden keine zusätzlichen Turbulenzen und Wirbel erzeugt. Es können mehrere MEMS-Sensoren in das gleiche Package montiert werden. Der Druck kann an vielen, eng benachbarten Stellen (Abstand Millimeter) oder auch weit voneinander entfernten Stellen (Abstand mehrere Meter) gemessen werden.

Die Gesamtdicke des Package kann deutlich geringer sein als die Gesamtdicke bisheriger Gehäuse von Sensoren. Da es aus lediglich zwei Lagen Folie besteht, welche den gehäuselosen MEMS-Sensor seitlich umgeben und somit nicht zur Dicke beitragen, oder einer Folie mit einer Lage Einbettmaterial, das wiederum als Folie betrachtet werden kann, ist das ganze Package genauso dick oder nicht wesentlich dicker als der MEMS-Sensor. Diese Dicke ist bevorzugt im Bereich von 100 µm bis 200 µm. Werden dünnere MEMS-Sensoren verwendet, kann die Dicke auch bis zu 40 µm reduziert werden. Wird ein stabileres Package gewünscht, so kann die Dicke auch bis zu 500 µm betragen.

Durch die beschriebene Kontaktierungstechnik werden sonst übliche Drahtbond-Kontakte zwischen Sensor-Baustein und umgebender Elektronik nicht mehr benötigt.

Weil das Package aus wenigen Lagen von Folien hergestellt wird, ist es im Gegensatz zu starren Leiterplatten flexibel, also biegbar. Es kann auf gekrümmte Oberflächen montiert werden. Es kann im aufgerollten Zustand verpackt und verkauft werden.

Fig. 2a zeigt eine Seitenansicht und Fig. 2b eine Draufsicht eines Beispiels eines MEMS-Sensors 100, der gehäust (verpackt) werden soll und die Form einer Treppe aufweist. Der MEMS-Sensor 100 weist ein MEMS-Substrat 102, eine MEMS-Kappe 104 und Kontaktpads 106 auf.

Wie in Fig. 3 in Draufsicht gezeigt ist, wird eine Folie 120 bereitgestellt. Die Folie 120 kann beispielsweise aus PI oder PEN bestehen, oder einem anderen elektrisch nicht leitfähigem, flexiblen Material. Die Folie 120 kann mit der gleichen Dicke wie die MEMS-Chip-Kappe 104 gewählt werden. Die Folie 120 ist oder wird mit einer Metallschicht versehen, die fotolithografisch strukturiert ist oder wird, um Folien-Anschlussflächen 122, die einer Kontaktpad-Geometrie des MEMS-Sensors 100 entsprechen, eine Fan-Out-Struktur 124 und größere Anschlusspads 126 zu erzeugen. Die Fan-Out-Struktur 124 stellt Leitungen dar, die die Folien-Anschlussflächen 122 mit den größeren Anschlusspads 126 elektrisch leitfähig verbinden.

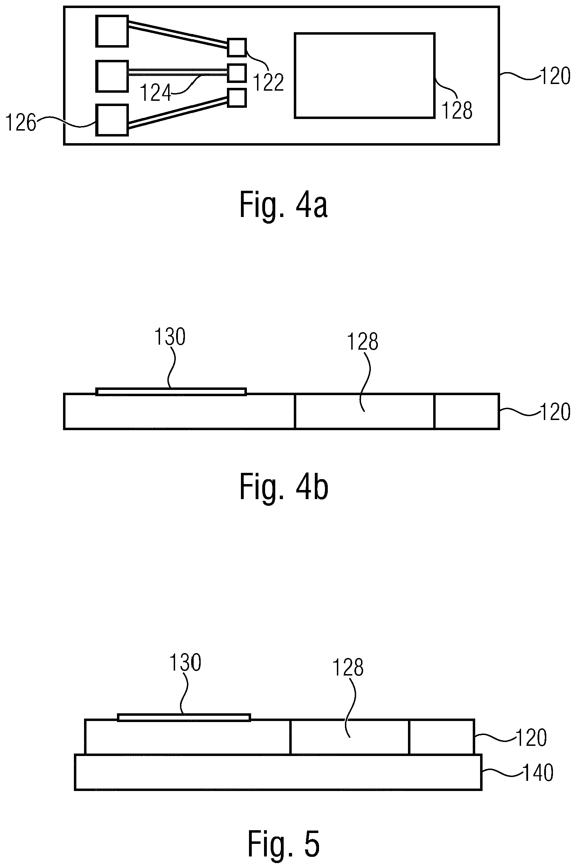

Wie in Fig. 4a als Draufansicht und in Fig. 4b als Querschnittansicht gezeigt ist, wird ein Loch 128 in die Folie geschnitten. An dieser Stelle sei angemerkt, dass in den Querschnittansichten der Fig. 4 bis 10 jeweils aus Gründen der Deutlichkeit keine Schraffur vorgesehen ist. Das Loch kann beispielsweise durch einen Laserprozess in die Folie 120 geschnitten werden. Die Dimension des Lochs 128entspricht ungefähr der Größe der MEMS-Kappe 104. In Fig. 4b ist die strukturierte Metallisierungsschicht auf der Folie 120 mit dem Bezugszeichen 130 bezeichnet.

Gemäß Fig. 5 wird die strukturierte Folie 120 vorübergehend auf einer ablösbaren Folie 140 laminiert. Die ablösbare Folie 140 kann z.B. eine Liner-Folie, eine Sägefolie, eine PET-Folie mit dünner Klebstoffbeschichtung, eine UV-Sägefolie usw. sein.

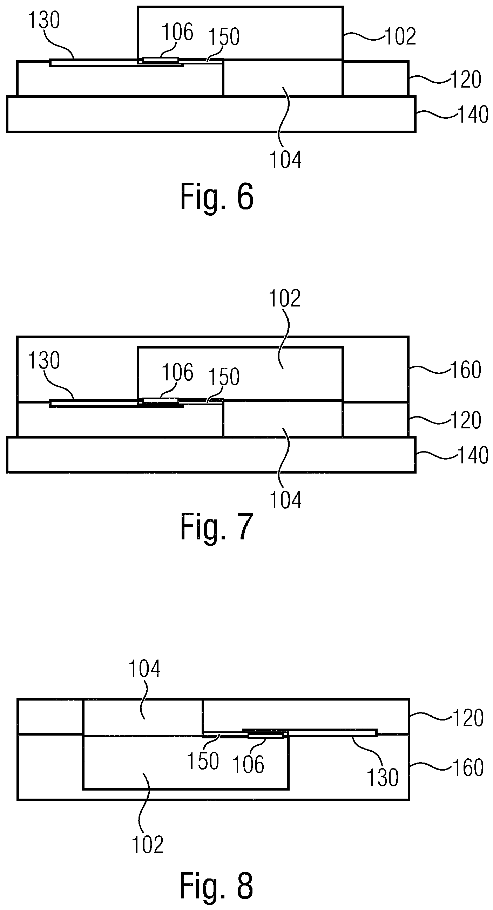

Auf die von der Folie 140 abgewandten Seite der strukturierten Folie 120 wird dann der MEMS-Sensor 100 aufgebracht, wie in Fig. 6 gezeigt ist. Bei Beispielen wird ein ACA-Klebstoff 150 (Anisotropic Conductive Adhesive = anisotroper leitfähiger Klebstoff) auf den Kontaktpad-Bereich dispensiert oder als trockener Film auflaminiert. Dann wird der MEMS-Sensor 100 beispielsweise durch einen Pick-and-Place-Prozess auf die Folien-Anschlussflächen 122 (Pads) und das Loch 128 ausgerichtet und platziert. Dadurch kommen die Kontaktpads 106 des MEM-Sensors 100 auf den Folien-Anschlussflächen 122 zu liegen und sind mit diesen über den leitfähigen Klebstoff 150 elektrisch verbunden.

Gemäß Fig. 7 wird eine flüssige Planarisierungsschicht 160 auf die von der ablösbaren Folie abgewandte Oberfläche aufgebracht und durch Tempern ausgehärtet, was zu einer nahezu flachen Oberflächentopographie führt. Die flüssige Planarisierungsschicht kann beispielsweise aus Permanent-Resist, Epoxy, Polymeren oder einem anderen geeigneten Material, das nach dem Aushärten zu einer flexiblen Schicht (Folie) führt, bestehen. Bei dem gezeigten Beispiel verbleibt über dem MEM-Substrat 102 auf der von dem MEMS-Deckel abgewandten Seite ein dünner Teil der Planarisierungsschicht 160. Bei Beispielen kann nach dem Aufbringen und Aushärten der Planarisierungsschicht 160 ein Dünnen der Planarisierungsschicht, z.B. durch chemisch-mechanisches Polieren, stattfinden, so dass die von der MEMS-Kappe 104 abgewandte Seite des MEMS-Substrats 102 freiliegt, was zu einer weiteren Reduzierung der Dicke des Package führen kann.

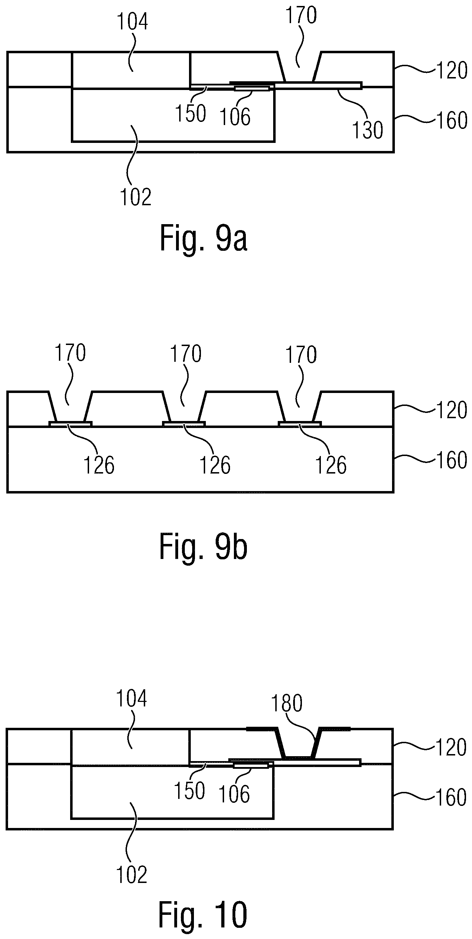

Fig. 8 zeigt den umgedrehten Folienstapel, wobei die ablösbare Folie 140 entfernt wurde.
Wie in der seitlichen Querschnittansicht von Fig. 9a und der frontalen Querschnittansicht von Fig. 9b gezeigt ist, werden dann beispielsweise durch einen Laser-Via-Prozess Kontaktlöcher 170 durch die Folie 120 geschnitten. Die Kontaktlöcher reichen bis zu der darunterliegenden Metallschicht 130, genauer gesagt bis zu den Kontaktpads 126 dieser Metallschicht 130.

Wie in Fig. 10 gezeigt ist, kann eine Verdrahtungsschicht 180 aus Metall aufgebracht werden, beispielsweise durch einen Sputterprozess, Aufdampfen usw., um den MEMS-Sensor mit einer externen Schaltung (nicht gezeigt) zu kontaktieren.

Technische Anwendungsgebiete von Beispielen der vorliegenden Offenbarung sind Sensoren für chemische Eigenschaften (pH-Wert, Gase und Ionen in Flüssigkeiten, Salzgehalt) und physikalische Eigenschaften (Temperatur, Druck, Schall, Strahlung, Beschleunigung). Insbesondere können Beispiele für Strömungssensoren, welche lokal den Druck auf gekrümmte Oberflächen messen sollen, ohne die Eigenschaft der Strömung (turbulent oder laminar) zu verändern, verwendet werden. Die Anwendung kann beispielsweise im Automobilbau (Design der Karosserie), in der Luftfahrt (Design von Tragflächen oder Oberflächen am Rumpf oder Leitwerk), bei Windkraftanlagen (Design von Flügeln), oder bei Schiffen (Rumpf, Schraube oder Segel) sein.

Beispiele der vorliegenden Offenbarung erzeugen ein dünnes Package für MEMS-Sensoren in einem zweilagigen Folienstapel, wobei die elektrische Kontaktierung des Sensors zu Leiterbahnen auf der Oberfläche der einen Folie erfolgt, welche der zweiten Folie zugekehrt ist (Innenseite) und wobei die Leiterbahnen mittels Durchkontaktierungen auf eine der äußeren Oberflächen geführt werden. Beispiele schaffen ein Package für MEMS-Sensoren mit einer Dicke, welche im Wesentlichen der Dicke der MEMS-Sensoren entspricht.

Die vorliegende Offenbarung ist jedoch nicht auf MEMS-Sensoranwendungen begrenzt. Vielmehr sind die hierin beschriebenen Techniken auch in allgemeiner Form auf vertikal gestapelte Chip-Anordnungen anwendbar, also dreidimensionale Stapel, die auch als "3D-IC" oder "3D-Chip-Stapel" bezeichnet werden. Bei Beispielen kann der Kern der Offenbarung darin gesehen werden, einen Zweier- oder auch Mehrfach-Stapel von Halbleiterbauelementen in ein Folien-Package zu integrieren, das letztlich auf einer mittleren Ebene des Chip-Stapels eine Kontaktierung des Chip-Stapels ermöglicht. Diese Möglichkeit der Kontaktierung und des Packaging ist nicht beschränkt auf MEMS-Bauelemente, sondern kann in gleicher Weise auch für andere Chip-Stapel genutzt werden, beispielsweise auch für Speicher-Chip-Stapel, die auch als sogenannte "memory stacks" bekannt sind, oder Kombinationen eines Prozessor-IC und eines Speicher-IC, sowie weiteren Kombinationen.

Beispiele der vorliegenden Offenbarung bieten somit allgemein eine Package-Lösung für 3D-integrierte IC und multifunktionale Chip-Stapel für zweilagige oder auch mehrlagige Chip-Stapel. Ein Vorteil von Beispielen der vorliegenden Offenbarung besteht darin, dass letztlich ein planes Chip-Package entsteht, und die ursprüngliche Topographie der Halbleiterbauelement-Anordnung, wie z.B. des IC-Stapels, ausgeglichen wird.

Obwohl manche Aspekte im Kontext eines Verfahrens zum Herstellen eines Package beschrieben wurden, ist klar, dass diese Aspekte auch eine Beschreibung eines entsprechenden Package darstellen. Analog dazu können Aspekte, die im Kontext eines Package beschrieben sind, auch eine Beschreibung eines entsprechenden Merkmals eines entsprechenden Verfahrens darstellen.

Die oben beschriebenen Beispiele sollen die Prinzipien der vorliegenden Offenbarung lediglich veranschaulichen. Es versteht sich, dass Modifikationen und Variationen der hierin beschriebenen Anordnungen und Einzelheiten Fachleuten einleuchten werden. Daher soll der Schutzbereich lediglich durch die folgenden Patentansprüche bestimmt sein.

## Patentansprüche

1. Verfahren zum Herstellen eines Halbleiterbauelement-Package mit folgenden Merkmalen:
Bereitstellen einer elektrisch isolierenden Folie mit Folien-Anschlusskontakten auf einer Oberfläche derselben und einer Öffnung durch dieselbe;
Aufbringen einer Halbleiterbauelement-Anordnung, die zumindest ein Trägerelement aufweist, auf dem ein vorstehendes Element und Element-Anschlusskontakte angeordnet sind, auf die Folie, wobei das vorstehende Element in die Öffnung eingebracht wird und die Element-Anschlusskontakte in Kontakt mit den Folien-Anschlusskontakten angeordnet werden;
Aufbringen einer Planarisierungsschicht über dem Trägerelement und der Folie.

2. Verfahren nach Anspruche 1, bei dem die Dicke der Folie mit Planarisierungsschicht im Wesentlichen der Dicke der Halbleiterbauelement-Anordnung entspricht.

3. Verfahren nach Anspruch 1 oder 2, bei dem vor dem Aufbringen der Halbleiterbauelement-Anordnung eine ablösbare Folie auf die Oberfläche der Folie aufgebracht wird, die den Folien-Anschlusskontakten gegenüberliegt, wobei die ablösbare Folie nach dem Aufbringen der Planarisierungsschicht entfernt wird.

4. Verfahren nach einem der Ansprüche 1 bis 3, das ferner ein Erzeugen einer Metallisierungsstruktur, die die Folien-Anschlusskontakte entsprechend einer Anschlusskontaktflächen-Geometrie der Halbleiterbauelement-Anordnung und eine Fan-Out-Struktur, die zu größeren Anschlusspads führt, auf der Folie aufweist.

5. Verfahren nach einem der Ansprüche 1 bis 4, bei dem vor dem Aufbringen der Halbleiterbauelement-Anordnung ein Klebstoff auf den Bereich der Folien-Anschlusskontakte aufgebracht wird.

6. Verfahren nach einem der Ansprüche 1 bis 5, das ferner ein Erzeugen von Kontaktöffnungen von der Oberfläche der Folie, die den Folien-Anschlusskontakten gegenüberliegt, her aufweist, die eine mit den Folien-Anschlusskontakten verbundene Metallisierung freilegen.

7. Verfahren nach Anspruch 6, bei dem die Öffnung und/oder die Kontaktöffnungen mittels Laserschneiden erzeugt werden.

8. Verfahren nach Anspruch 6 oder 7, bei dem eine Anschlussverdrahtung für die Halbleiterbauelement-Anordnung durch die Öffnungen erzeugt wird.

9. Verfahren nach einem der Ansprüche 1 bis 8, bei dem die Halbleiterbauelement-Anordnung ein MEMS-Chip ist, das Trägerelement ein MEMS-Substrat ist und das vorstehende Element eine MEMS-Kappe ist.

10. Verfahren nach einem der Ansprüche 1 bis 9, bei dem das vorstehende Element zumindest einen Halbleiterchip aufweist, und das Trägerelement ein Verdrahtungssubstrat oder ein Halbleitersubstrat aufweist.

11. Verfahren nach einem der Ansprüche 1 bis 9, bei dem das vorstehende Element einen ersten Halbleiterchip aufweist und das Trägerelement einen zweiten Halbleiterchip aufweist, wobei der erste Halbleiterchip und die Element-Anschlusskontakte auf einer Oberfläche des zweiten Halbleiterchips angeordnet sind.

12. Ein dünnes Package für eine Halbleiterbauelement-Anordnung, die ein Trägerelement aufweist, auf dem ein vorstehendes Element und Element-Anschlusskontakte angeordnet sind, in einem zweilagigen Folienstapel, wobei eine elektrische Kontaktierung der Halbleiterbauelement-Anordnung zu Leiterbahnen auf der Oberfläche einer der Folien erfolgt, die einer zweiten der Folien zugekehrt ist, indem die Element-Anschlusskontakte auf Folien-Anschlusskontakten, die sich auf der Oberfläche der einen der Folien befinden, angeordnet sind, wobei die Leiterbahnen mittels Durchkontaktierungen auf eine der äußeren Oberflächen geführt sind, und wobei das vorstehende Element in einer Öffnung der einen der beiden Folien angeordnet ist.

13. Ein dünnes Package für eine Halbleiterbauelement-Anordnung nach Anspruch 12, bei dem die Halbleiterbauelement-Anordnung ein MEMS-Sensorchip, das vorstehende Element eine MEMS-Kappe und das Trägerelement ein MEMS-Substrat ist.

14. Ein dünnes Package für eine Halbleiterbauelement-Anordnung nach Anspruch 12, bei dem das vorstehende Element einen Halbleiterchip aufweist und das Trägerelement einen weiteren Halbleiterchip, ein Halbleitersubstrat oder ein Verdrahtungssubstrat aufweist.

15. Ein dünnes Package für eine Halbleiterbauelement-Anordnung nach Anspruch 12, das unter Verwendung eines Verfahrens nach einem der Ansprüche 1 bis 12 hergestellt wurde.
